# EUROPÄISCHE PATENTANMELDUNG

(11) **EP 1 641 328 A2**
(43) Veröffentlichungstag der Anmeldung: **29.03.2006**
(21) Anmeldenummer: 05008443.3
(22) Anmeldetag: 19.04.2005
(51) Int. Cl.: H05K 1/00, H05K 1/11, H05K 3/10

(54) **Formteil mit elektrischer Leiterbahn**

(30) Priorität: 23.09.2004 DE 102004047590
(71) Anmelder: Walter Esser, Kunststoff-Spritzgiesserei GmbH & Co. KG, 26446 Friedeburg (DE)
(72) Erfinder: Tobiassen, Frank, 26316 Varel (DE); Coordes, Uwe, 26446 Friedeburg (DE); Junginger, Klaus Dr., 26446 Friedeburg (DE)
(74) Vertreter: Hoeger, Stellrecht & Partner Patentanwälte

(57) **Zusammenfassung**

Um ein mit mindestens einer Leiterbahn versehenes Formteil, umfassend ein Trägerteil aus geformtem Kunststoff, mindestens einen an dem Trägerteil vorgesehenen und die mindestens eine Leiterbahn festlegenden Pfad aus galvanisierbarem Kunststoffmaterial, welcher mindestens eine die mindestens eine Leiterbahn bildende leitfähige Schicht trägt, derart weiterzubilden, daß die mindestens eine Leiterbahn einfach und sicher kontaktierbar ist, wird vorgeschlagen, daß zur Bildung mindestens einer Anschlußstelle der mindestens einen Leiterbahn in dem Trägerteil ein eine Aufnahme für einen einsetzbaren Kontakt aufweisendes Aufnahmeteil aus einem galvanisierbaren und zugfesteren Material als das Kunststoffmaterial des Trägerteils und/oder des Pfades sitzt, an welches der mindestens eine Pfad angrenzt, und daß die von dem mindestens einen Pfad getragene elektrisch leitfähige Schicht in dessen Aufnahme des Aufnahmeteils hineinverläuft.

## Beschreibung

Mit mindestens einer elektrischen Leiterbahn versehenes Formteil, umfassend ein Trägerteil aus geformtem Kunststoff, mindestens einen an dem Trägerteil vorgesehenen und die mindestens eine Leiterbahn festlegenden Pfad aus galvanisierbarem Kunststoffmaterial, welcher mindestens eine die mindestens eine Leiterbahn bildende leitfähige Schicht trägt.

Derartige Formteile werden üblicherweise als MID-Formteile, das heißt Molded Interconnect Devices, bezeichnet, die als komplexe Schaltungsträger in der Elektro- oder in der Elektronikindustrie dienen. Derartige als Schaltungsträger eingesetzte Formteile verbinden immer häufiger elektrische und mechanische Elemente auf einer fast beliebig räumlich geformten dreidimensionalen Oberfläche.

Bei diesen Formteilen besteht die Notwendigkeit, die mindestens eine Leiterbahn in geeigneter Weise kontaktieren zu können.

Aufgrund der komplexen Form der Formteile ist ein Lötverfahren zur Kontaktierung der mindestens einen Leiterbahn teilweise aufwendig.

Der Erfindung liegt daher die Aufgabe zugrunde ein gattungsgemäßes Formteil derart weiterzubilden, daß die mindestens eine Leiterbahn einfach und sicher kontaktierbar ist.

Diese Aufgabe wird bei einem Formteil der eingangs beschriebenen Art erfindungsgemäß dadurch gelöst, daß zur Bildung mindestens einer Anschlußstelle der mindestens einen Leiterbahn in dem Trägerteil ein eine Aufnahme für einen einsetzbaren Kontakt aufweisendes Aufnahmeteil aus einem galvanisierbaren und zugfesteren Material als das Kunststoffmaterial des Trägerteils und/oder des Pfades sitzt, an welches der Pfad angrenzt, und daß die von dem Pfad getragene elektrisch leitfähige Schicht in die Aufnahme des Aufnahmeteils hineinverläuft.

Der Vorteil der erfindungsgemäßen Lösung ist darin zu sehen, daß mit einem derart eingesetzten Aufnahmeteil die Möglichkeit besteht, in einfacher Art und Weise eine für einen beliebigen Kontakt geeignete Aufnahme zu realisieren, die eine weit höhere Stabilität als das Kunststoffmaterial des Trägerteils und/oder das galvanisierbare Kunststoffmaterial aufweist. Somit ist mit einem derartigen Aufnahmeteil ein sicherer und langzeitstabiler elektrischer Kontakt mit der mindestens einen Leiterbahn herstellbar ist.

Hinsichtlich der Verankerung des Aufnahmeteils in den Trägerteil wurden bislang keine näheren Angaben gemacht. So sieht ein vorteilhaftes Ausführungsbeispiel vor, daß das Aufnahmeteil in einen Durchbruch des Trägerteils eingepreßt ist.

Damit besteht die Möglichkeit, das Aufnahmeteil entweder vor oder nach Herstellung der Pfade an dem Trägerteil in den Durchbruch einzusetzen und durch Einpressen zu fixieren.

Ein andere vorteilhafte Lösung sieht vor, daß das Aufnahmeteil in das Trägerteil eingeformt ist.

Bei einem derartigen Einformen des Aufnahmeteils in das Trägerteil erfolgt das Einsetzen des Aufnahmeteils bereits bei Herstellung der Trägerteils, beispielsweise im Zuge eines Spritzgießens des Trägerteils selbst.

Um eine möglichst gute Fixierung des Aufnahmeteils in dem Trägerteil zu erreichen, ist vorzugsweise vorgesehen, daß das Aufnahmeteil ein Verankerungselement trägt, das eine formschlüssige Verbindung mit einem dieses umgebenden Wandbereich des Trägerteils eingeht. Damit besteht die Möglichkeit, das Aufnahmeteil mit der notwendigen Stabilität zu verankern. Eine derartige stabile Verankerung ist insbesondere notwendig, um die als dünne Schicht über die Pfade auf das Aufnahmeteil verlaufende Leiterbahn im Laufe der Zeit aufgrund einer Relativbewegung des Aufnahmeteils zum jeweiligen Wandbereich nicht zu beschädigen oder zu zerstören.

Derartige Verankerungselemente könnten, insbesondere wenn ein Einformen des Aufnahmeteils im Zuge der Herstellung des Trägerteils erfolgt, unterschiedlichster Art sein. Beispielsweise können derartige Verankerungselemente Fortsätze oder Flügel sein, die sich in den dieses umgebenden Wandbereich hineinerstrecken.

Eine relativ einfach herzustellende und universelle Ausführung des Aufnahmeteils sieht vor, daß das Verankerungselement als Bund ausgebildet ist, welcher einfach herstellbar ist und eine verbesserte Abstützung des Aufnahmeteils in dem Wandbereich gewährleistet.

Vorzugsweise ist dabei der Bund auf der Seite des Aufnahmeteils angeordnet, von welcher ausgehend ein Einsetzen des Kontakts erfolgt.

Prinzipiell kann die Aufnahme des Aufnahmeteils beliebig ausgebildet sein, insbesondere für jede lötfreie Verbindung geeignet ausgebildet sein.

Beispielsweise wäre es denkbar, die Aufname als Gewinde auszubilden.

Eine hinsichtlich der Fertigungstechnologie besonders günstige Lösung sieht vor, daß das Aufnahmeteil als Aufnahme einen Preßsitz für einen einzupressenden Kontakt aufweist.

Eine derartige Einpreßverbindung zwischen Kontakt und Preßsitz ist eine besonders einfache und mit geringem Zeitaufwand in der Fertigung herzustellende Verbindung.

Um den Preßsitz mit möglichst guter elektrischer Kontaktierung ausführen zu können, ist es besonders günstig, wenn der Preßsitz eine strukturierte Oberfläche aufweist, so daß lokal erhöhte Flächenpressungen zwischen dem Preßsitz und dem Kontaktstift auftreten, die eine gute elektrisch leitenden Verbindung ergeben.

Ergänzend oder alternativ zum Vorsehen eines Preßsitzes ist bei einem weiteren Ausführungsbeispiel der erfindungsgemäßen Lösung vorgesehen, daß das Aufnahmeteil in einen Einsteckkanal desselben hineinragende Federelemente umfaßt.

Mit derartigen Federelementen besteht die Möglichkeit, im wesentlichen jede Art von Kontakten, insbesondere Kontaktstifte, zuverlässig in dem Aufnahmeteil zu kontaktieren.

Dabei sind die Federelemente vorzugsweise so ausgebildet, daß sie einen im Querschnitt verengten Bereich im Einsteckkanal bilden und dieser im Querschnitt verengte Bereich bei Einstecken des Kontakts wieder geweitet wird, so daß die Federelemente dann kraftbeaufschlagt an dem Kontakt anliegen.

Besonders günstig ist dabei noch eine Lösung, bei welcher die Federelemente im Sinne von Widerhaken auf den Kontakt wirken, so daß ein Herausziehen des Kontakts entgegengesetzt zu einer Einsteckrichtung durch die Federelemente verhindert wird und somit eine sichere und auch gegen Lösen gesicherte Kontaktierung des Kontakts in dem Aufnahmeteil gewährleistet ist.

Auch die Ausbildung des Aufnahmeteils kann in verschiedener Art und Weise erfolgen. Beispielsweise könnte das Aufnahmeteil ein rechteckförmiges, in das Trägerteil einzubettendes Teil sein.

Eine besonders günstige Lösung sieht vor, daß das Aufnahmeteil als Hülse ausgebildet ist.

Hinsichtlich des Materials des Aufnahmeteils wurden ebenfalls keine näheren Angaben gemacht und so wäre es beispielsweise denkbar, das Aufnahmeteil aus einem galvanisierbaren, jedoch in Umfangsrichtung eine hohe Zugfestigkeit aufweisenden Material auszubilden, das sich um die Aufnahme herum erstreckt.

Ein derartiges Material wäre beispielsweise ein auf Kohlenstofffasern basierendes Material, beispielsweise auch eine Kohlenstofffaserkeramik.

Eine andere vorteilhafte Lösung sieht vor, daß das Aufnahmeteil aus Metall ist.

Im Zusammenhang mit der bisher beschriebenen Lösung der erfindungsgemäßen Aufgabe wurden bislang lediglich das Formteil selbst betreffende Merkmale erläutert.

Die eingangs genannte Aufgabe wird aber insbesondere auch durch ein Verfahren zum Herstellen eines mit mindestens einer elektrischen Leiterbahn versehenen Formteils mit den Schritten:
- Herstellen eines Trägerteils als Formteil aus Kunststoff;
- Anbringen mindestens eines den Verlauf der mindestens einen Leiterbahn festlegenden Pfades aus galvanisierbarem Kunststoffmaterial an dem Trägerteil;
- Aufbringen mindestens einer die mindestens eine Leiterbahn bildenden elektrisch leitfähigen Schicht auf dem mindestens einen Pfad,
erfindungsgemäß dadurch gelöst, daß das Trägerteil vor dem Aufbringen der elektrisch leitfähigen Schicht mit einem Aufnahmeteil aus galvanisierbarem und zugfesteren Material als das Kunststoffmaterial des Trägerteils und/oder des mindestens einen Pfades versehen wird und daß die elektrisch leitfähige Schicht derart aufgebracht wird, daß sie von dem Pfad in eine Aufnahme des Aufnahmeteils hineinverläuft.

Das Aufbringen des galvanisierbaren Pfades bei dem erfindungsgemäßen Trägerteil kann in unterschiedlichster Art und Weise erfolgen.

Eine günstige Möglichkeit sieht dabei vor, daß das Anbringen des Pfades aus galvansierbarem Kunststoffmaterial ein Aufbringen von galvanisierbarem Kunststoffmaterial auf das Trägerteil umfaßt.

So ist es beispielsweise denkbar, in dem Trägerteil Vertiefungen vorzusehen, in denen in einem zweiten Herstellungsvorgang galvanisierbares Kunststoffmaterial eingebracht wird, so daß der Verlauf der Vertiefungen den mindestens einen Pfad festlegt.

Eine weitere Möglichkeit, einen derartigen Pfad herzustellen, ist das Aufbringen einer Heißprägefolie, welche allerdings für komplexe dreidimensionale geometrische Strukturen nicht geeignet ist.

Andererseits ist es aber auch denkbar, den Pfad dadurch herzustellen, daß das gesamte Trägerteil aus einem metallisierbaren Kunststoffmaterial hergestellt wird und die nicht die Pfade bildenden Oberflächen nachfolgend abgedeckt werden.

Eine weitere vorteilhafte Möglichkeit sieht vor, daß das Anbringen des Pfades aus galvanisierbarem Kunststoffmaterial durch eine oberflächliche Veränderung des Kunststoffmaterials des Trägerteils erfolgt.

Eine derartige oberflächliche Veränderung des Kunststoffmaterials des Trägerteils ist beispielsweise durch Bestrahlung des Kunststoffmaterials im Bereich der Pfade möglich, wobei die Bestrahlung, beispielsweise mit Laserstrahlung, entweder eine chemische Veränderung des Kunststoffmaterials oder eine mechanische Veränderung desselben, beispielsweise ein Aufrauhen desselben, bewirkt und somit die Galvanisierbarkeit im Bereich der Pfade im Gegensatz zu den Bereichen außerhalb der Pfade ermöglicht.

Weitere Merkmale und Vorteile der Erfindung sind Gegenstand der nachfolgende Beschreibung sowie der zeichnerischen Darstellung eines Ausführungsbeispiels. In der Zeichnung zeigen:
- Figur 1: eine perspektivische Darstellung eines Trägerteils für ein erfindungsgemäßes Formteil;

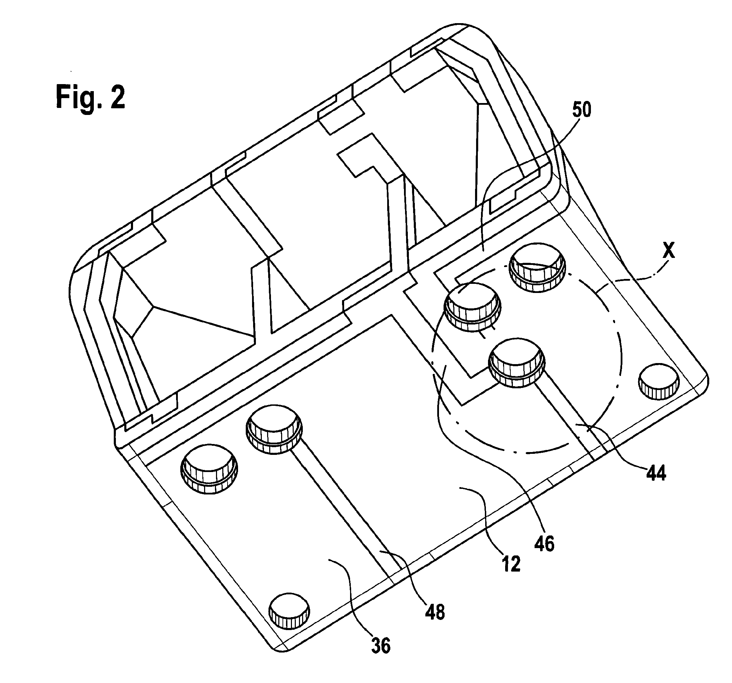

- Figur 2: eine perspektivische Darstellung ähnlich Figur 1 des Trägerteils mit in Vertiefungen des Trägerteils eingebrachtem galvanisierbaren Kunststoffmaterial zur Festlegung von Pfaden;
- Figur 3: eine vergrößerte Darstellung des Bereichs X in Figur 2;
- Figur 4: eine perspektivische Darstellung ähnlich Figur 2 bei in das Trägerteil eingesetzten Aufnahmeteilen;
- Figur 5: ein Schnitt längs Linie 5-5 in Figur 4;
- Figur 6: eine Darstellung ähnlich Figur 5 mit einer eine Leiterbahn bildenden Schicht;
- Figur 7: eine Darstellung ähnlich Figur 6 mit einem in das Aufnahmeteil eingepreßten Kontaktstift;
- Figur 8: einen Schnitt ähnlich Figur 7 eines zweiten Ausführungsbeispiels eines erfindungsgemäßen Formteils;
- Figur 9: einen Schnitt ähnlich Figur 5 bei einem dritten Ausführungsbeispiel eines erfindungsgemäßen Formteils;
- Fig. 10: eine Darstellung ähnlich Fig. 2 bei einem vierten Ausführungsbeispiel eines erfindungsgemäßen Formteils;
- Fig. 11: eine Darstellung ähnlich Fig. 3 bei dem vierten Ausführungsbeispiel des erfindungsgemäßen Formteils;
- Fig. 12: eine Darstellung ähnlich Fig. 7 bei dem vierten Ausführungsbeispiel des erfindungsgemäßen Formteils;
- Fig. 13: eine Darstellung ähnlich Fig. 6 bei einem fünften Ausführungsbeispiel eines erfindungsgemäßen Formteils und
- Fig. 14: eine Darstellung ähnlich Fig. 7 bei dem fünften Ausführungsbeispiel des erfindungsgemäßen Formteils.

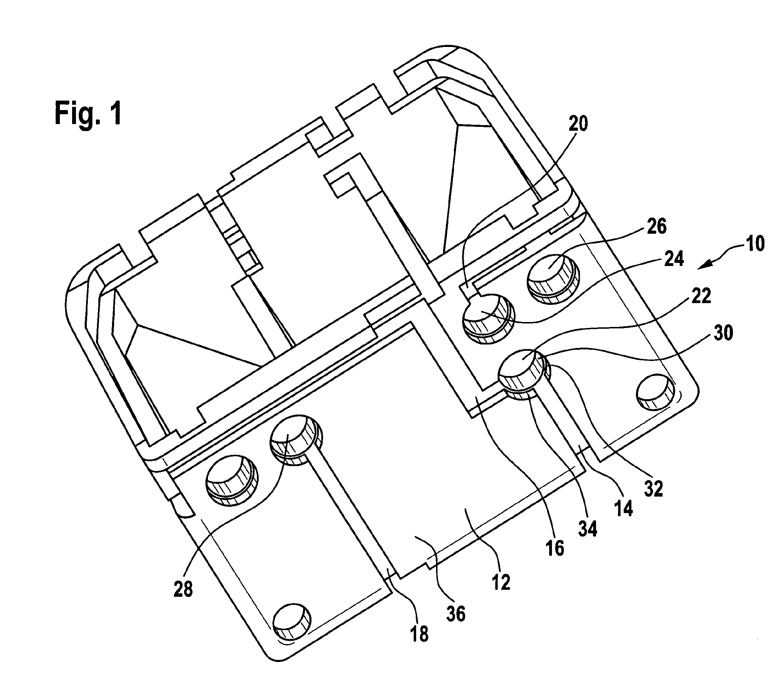

Ein erstes Ausführungsbeispiel eines erfindungsgemäßen Formteils umfaßt ein in Figur 1 dargestelltes und als Ganzes mit 10 bezeichnetes Trägerteil, vorzugsweise hergestellt aus Kunststoff, beispielsweise durch Spritzgießen von Kunststoff, in dessen Wände, beispielsweise in der Bodenwand 12, Vertiefungen 14, 16, 18, 20, im einfachsten Fall ausgeführt als Nuten, eingeformt sind.

Ferner sind beispielsweise in der Bodenwand 12 Durchbrüche 22, 24, 26, 28 vorgesehen, welche stufenförmig ausgebildet sind und dabei einen hinsichtlich ihres Durchmessers verengten Bereich 30 aufweisen, welcher über eine Stufe 32 in einen hinsichtlich des Durchmessers erweiterten Bereich 34 übergeht.

Der erweiterte Bereich 34 liegt dabei auf einer einer Unterseite 36 der Bodenwand zugewandten Seite, von welcher sich ausgehend auch die Vertiefungen 14, 16, 18, 20 in die Bodenwand 12 hineinerstrecken, welche im Falle der Durchbrüche 22 und 24 jeweils dann in den erweiterten Bereich 34 des jeweiligen Durchbruchs 22, 24, 28 übergehen.

In diese Vertiefungen 14, 16, 18, 20 läßt sich dann in einem zweiten Arbeitsgang, beispielsweise ebenfalls durch Spritzgießen, ein galvanisierbarer Kunststoff einbringen, welcher die Vertiefungen 14, 16, 18, 20 ausfüllt und dem Verlauf der Vertiefungen 14, 16, 18, 20 beispielsweise in der Bodenwand 12 entsprechende Pfade 44, 46, 48, 50 bildet, die auf der Unterseite 36 der Bodenwand 12 entsprechend dem Verlauf der Vertiefungen 14, 16, 18, 20 verlaufen, wobei dadurch, daß der Kunststoff galvanisierbar ist, die dabei entstehenden Pfade 44, 46, 48, 50, ihrerseits galvanisierbar sind.

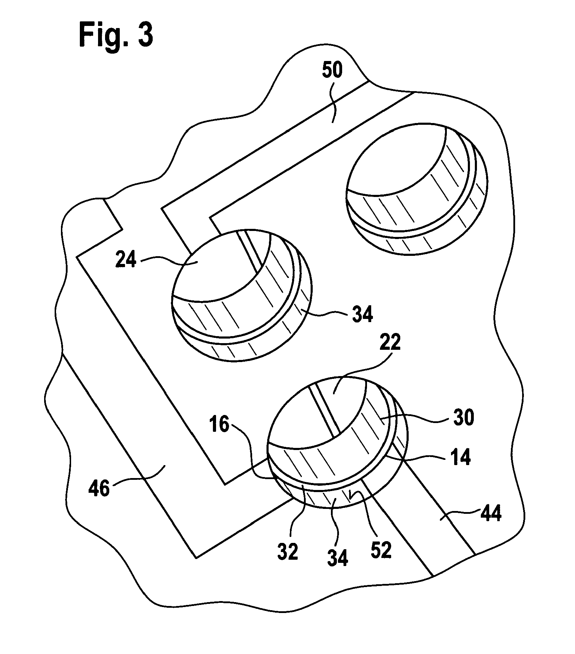

Wie vergrößert in Figur 3 dargestellt, erstreckt sich das in die Vertiefungen 14, 16 eingebrachte Kunststoffmaterial bis an den erweiterten Bereich 34 des jeweiligen Durchbruchs, beispielsweise des Durchbruchs 32, und ergänzt eine Innenwand 52 des erweiterten Bereichs 34 in den Bereichen, in denen in den erweiterten Bereich 34 die Vertiefungen, beispielsweise die Vertiefungen 14 und 16, einmündeten.

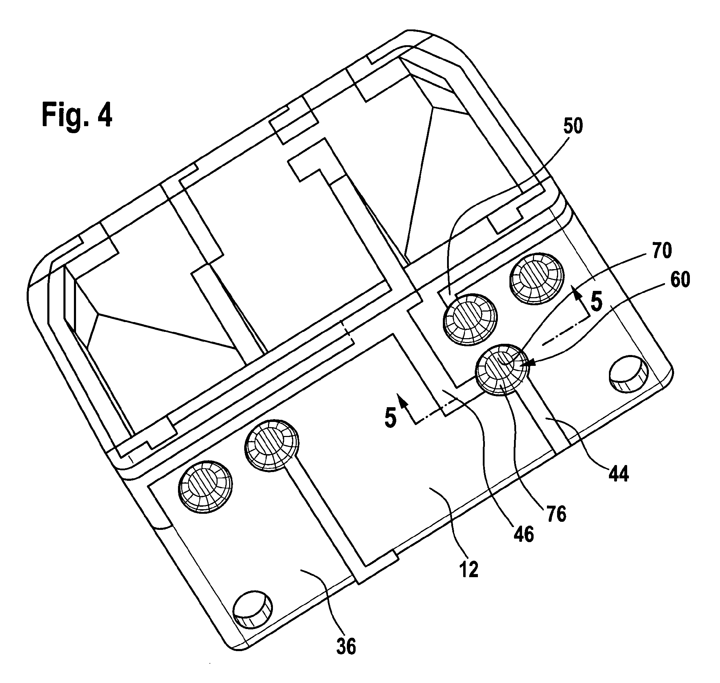

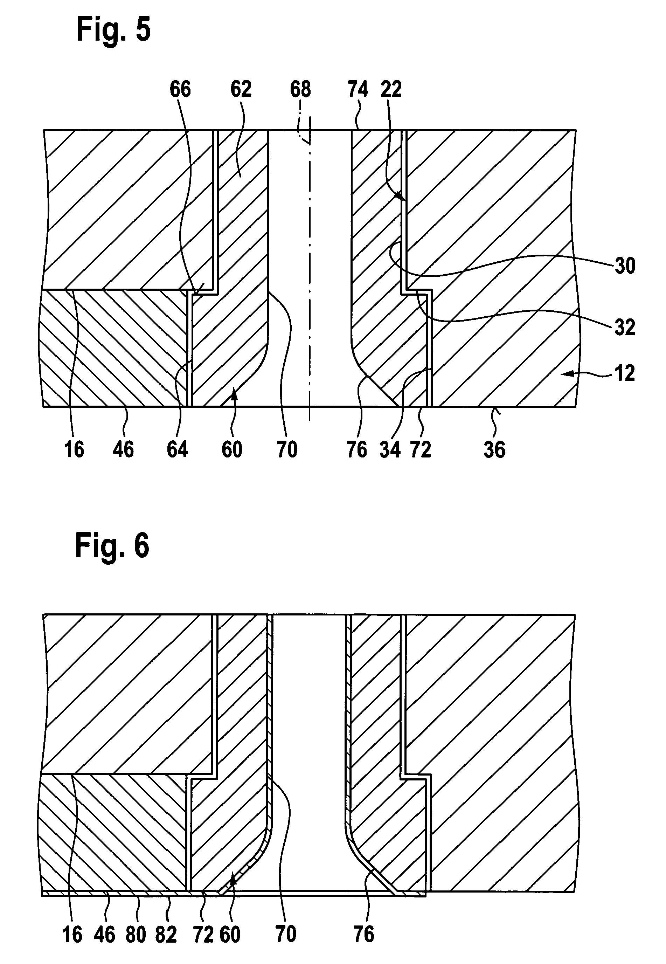

Wie in Figur 4 und Figur 5 dargestellt, sind in die Durchbrüche, beispielsweise in den Durchbruch 22, hülsenförmige Aufnahmeteile 60 eingesetzt, welche einen Zylinderabschnitt 62 und einen sich gegenüber dem Zylinderabschnitt 62 erweiternden Bund 64 aufweisen, so daß der Zylinderabschnitt 62 in dem verengten Bereich 30 des jeweiligen Durchbruchs, beispielsweise des Durchbruchs 22, sitzt und der Bund 64 in dem erweiterten Bereich 34 des jeweiligen Durchbruchs, beispielsweise des Durchbruchs 22, sitzt und sich außerdem das Aufnahmeteil mit einer Flanschfläche 66 am Übergang vom Bund 64 zum zylindrischen Abschnitt 62 an der Stufe 32 des jeweiligen Durchbruchs, beispielsweise des Durchbruchs 22, abstützen kann.

Das Aufnahmeteil 60 umfaßt einen Einsteckkanal 70, welcher sich in Richtung einer Mittelachse 68 des Aufnahmeteils 60 von einer ersten Stirnseite 72 bis zu einer zweiten Stirnseite 74 erstreckt und welcher zur ersten Stirnseite 72 hin einen erweiterten Bereich 76 aufweist, welcher ein Einführen eines Kontaktstifts erleichtert.

Beispielsweise ist, wie in Figur 5 dargestellt, die erste Stirnseite 72 des Aufnahmeteils 60 im wesentlichen fiuchtend mit der Unterseite 36 der Bodenwand 12 angeordnet, so daß von der Unterseite 36 her der Kontaktstift in den Einsteckkanal 70 des Aufnahmeteils 60 einschiebbar ist.

Das Aufnahmeteil 60 ist dabei ebenfalls aus einem galvanisierbaren Material hergestellt und außerdem aus einem Material, welches eine größere Zugfestigkeit aufweist als das Kunststoffmaterial zur Herstellung des Trägerteils 10 und das in die Vertiefungen 14, 16, 18, 20 einbringbare Kunststoffmaterial zur Bildung der Pfade 44, 46, 48, 50.

Im einfachsten Fall ist das Aufnahmeteil 60 aus Metall hergestellt.

Bei einer Galvanisierung der Pfade 44, 46, 48, 50, beispielsweise der Galvanisierung des Pfads 46, wie in Figur 6 dargestellt, wird auf dem Pfad 46 eine Schicht 80 aus elektrisch leitfähigem Material abgeschieden, die sich allerdings nicht nur über den Pfad 46 hinweg erstreckt, sondern auch bis zum Aufnahmeteil 60, und über dessen erste Stirnseite 72 hinweg über den erweiterten Bereich 76 bis in den Einsteckkanal 70 hineinverläuft.

Damit bildet die Schicht 80 eine elektrische Leiterbahn 82, die sich ausgehend von dem Einsteckkanal 70 über den erweiterten Bereich 76 und längs des jeweiligen Pfades 46 erstreckt und beispielsweise ein elektrisches oder elektronisches Bauteil mit dem Einsteckkanal 70 elektrisch leitend verbindet (Fig. 6).

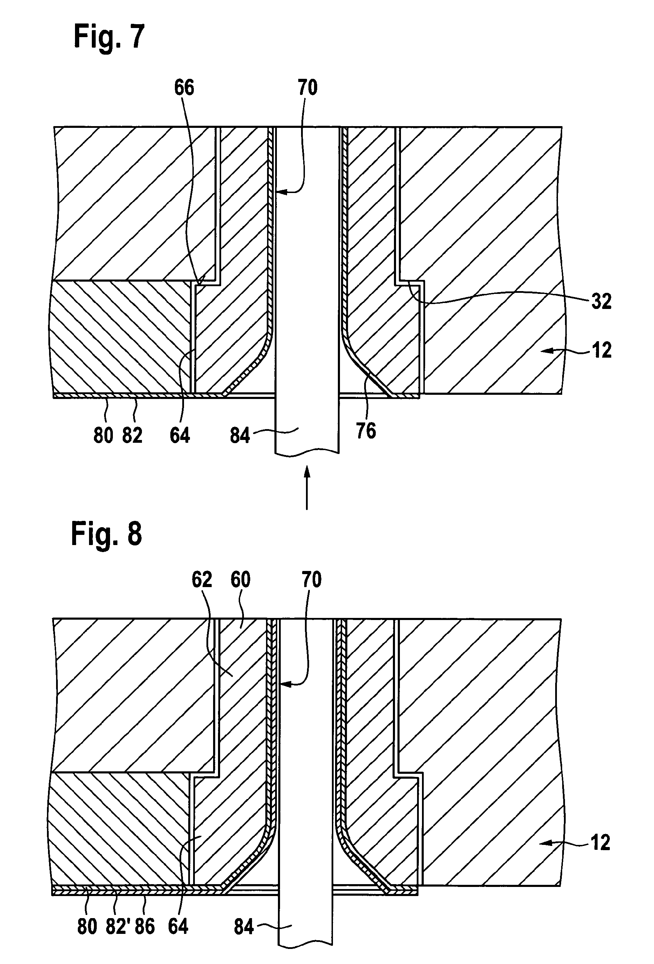

Um nun über den Einsteckkanal 70 einen äußeren Anschluß herstellen zu können, ist in den Einsteckkanal 70, beschichtet mit der die Leiterbahn 82 bildenden Schicht 80 der Kontaktstift 84 einsetzbar, vorzugsweise einpreßbar, so daß eine kraftschlüssige Verbindung zwischen der Leiterbahn 82 in dem Einsteckkanal 70 und dem Kontaktstift 84 entsteht (Fig. 7).

Vorzugsweise erfolgt ein Einpressen des Kontaktstifts 84 von der Stirnseite 72 des Aufnahmeteils 60 ausgehend, an welcher der Bund 64 angeordnet ist, so daß sich das Aufnahmeteil 60 mit dem Bund 64 und der Flanschfläche 66 an der Stufe 32 abstützen kann und die Einpreßkraft des Kontaktstifts 84 in die Bodenwand 12 eingeleitet werden kann.

Die erfindungsgemäße Lösung bietet somit die Möglichkeit, ein Formteil herzustellen, bei welchem mindestens eine Leiterbahn 82 über das Aufnahmeteil 60 mittels des Kontaktstifts 84 extern kontaktierbar ist und somit eine einfache Möglichkeit, zur Herstellung derartiger Formteile, umfassend das dreidimensional als Formkörper aus Kunststoff hergestellte Trägerteil 10 und auf dem Trägerteil durch die Pfade 44, 46, 48, 50 definierte elektrische Leiterbahnen 82, die in beliebiger Weise in dem dreidimensionalen Formteil zur elektrischen oder elektronischen Bauteilen geführt werden können.

Andererseits bietet sich die Möglichkeit derartige elektrische Leiterbahnen 82 in zeitsparender Weise, insbesondere lötfrei, über die Kontaktstifte 84 zu kontaktieren.

Bei einem zweiten Ausführungsbeispiel eines erfindungsgemäßen Formteils, werden, wie in Figur 8 dargestellt, die Leiterbahnen 82' nicht durch eine einzige Schicht 80 gebildet, sondern beispielsweise durch die erste durch Galvanisieren aufgetragene Schicht 80 und eine auf dieser ersten Schicht 80 aufgetragene zweite, veredelte Schicht 86, welche die elektrische Leitfähigkeit und Korrosionsbeständigkeit sowie die Kontaktierbarkeit mittels des Kontaktstifts 84 noch weiter verbessert.

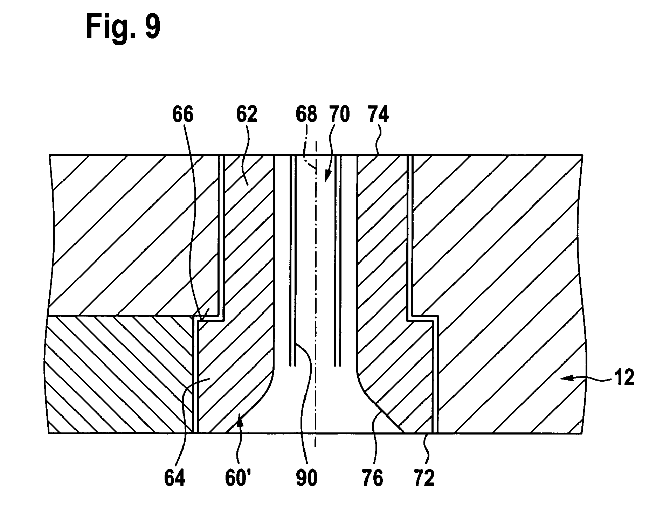

Bei einem dritten, in Figur 9 dargestellten Ausführungsbeispiel sind die Aufnahmeteile 60' in Abwandlung von den Aufnahmeteilen 60 gemäß den bisherigen Ausführungsformen im Einsteckkanal 70 mit in Richtung von dessen Mittelachse 68 verlaufenden Rippen 90 versehen, welche die Möglichkeit eröffnen, lokal auf die Kontaktstifte 84, insbesondere umfänglich derselben beim Einpressen der Kontaktstifte 84 größere Preßkräfte und somit eine noch bessere elektrische Verbindung zwischen der Leiterbahn 82 oder 82' und dem Kontaktstift 84 zu erzeugen.

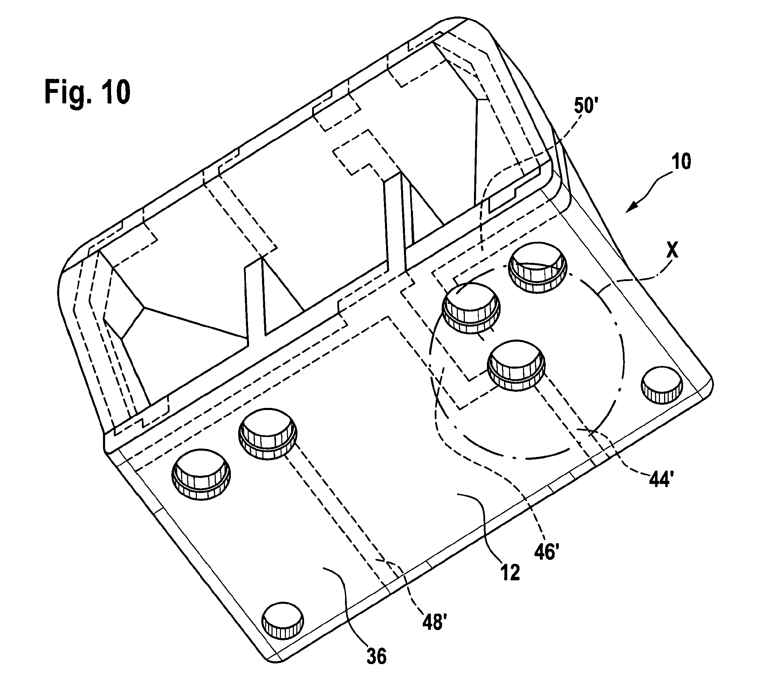

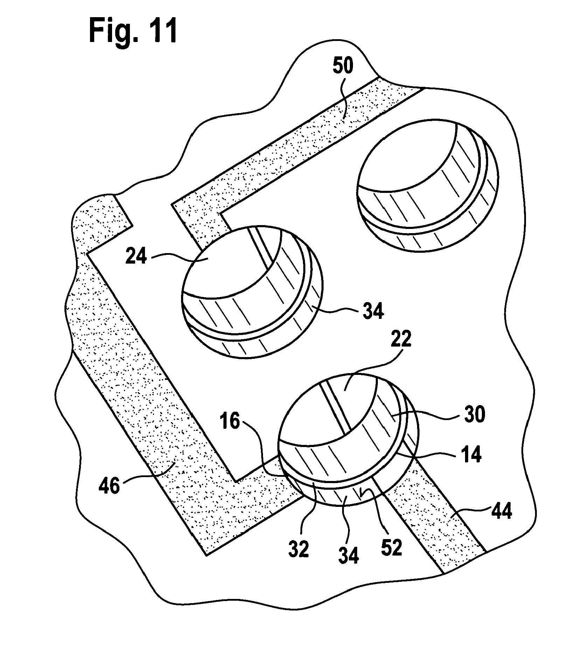

Bei einem vierten Ausführungsbeispiel eines erfindungsgemäßen Formteils, dargestellt in den Fig. 10 bis 11, werden die galvanisierbaren Pfade 44, 46, 48, 50 nicht dadurch hergestellt, daß ein galvanisierbarer Kunststoff in Vertiefungen eingebracht wird, sondern dadurch, daß der Kunststoff, aus dem das Trägerteil 10 hergestellt wird, oberflächlich im Bereich der Pfade 44', 46', 48', 50' in eine galvanisierbare Form gebracht wird.

Ein derartiges Überführen des Kunststoffes des Trägerteils 10 in galvanisierbare Pfade, erfolgt beispielsweise durch verändern der chemischen Struktur des Kunststoffs und/oder durch Aufrauhen des Kunststoffs durch Einwirkung von Strahlung, beispielsweise Laserstrahlung im Bereich der Pfade 44', 46', 48', 50', so daß das Einbringen von galvanisierbarem Kunststoff in Vertiefungen entfallen kann und somit nur noch eine oberflächliche Umwandlung des Kunststoffs zur Herstellung der elektrischen Leiterbahn 82 auf dem Trägerteil 10 erfolgen muß.

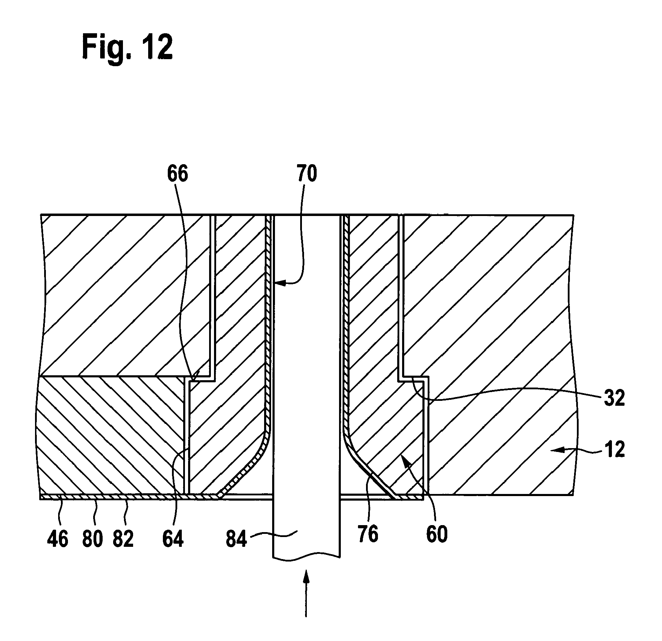

Durch den nachfolgenden Galvanisierungsschritt wird auf diese Pfade 44, 46, 48, 50 nach Einsetzen der Aufnahmeteile 60 im Rahmen der Galvanisierung die Schicht 80 abgeschieden, die die elektrische Leiterbahn 82 bildet und sich, wie in Fig. 12 dargestellt, in den Einsteckkanal 70 hineinerstreckt.

Damit sind bei dem vierten Ausführungsbeispiel, dargestellt in den Fig. 10 bis 12, dieselben Vorteile erreichbar, wie bei dem ersten Ausführungsbeispiel, ohne daß ein Auftragen eines galvanisierbaren Kunststoffs auf das Trägerteil 10 erforderlich ist.

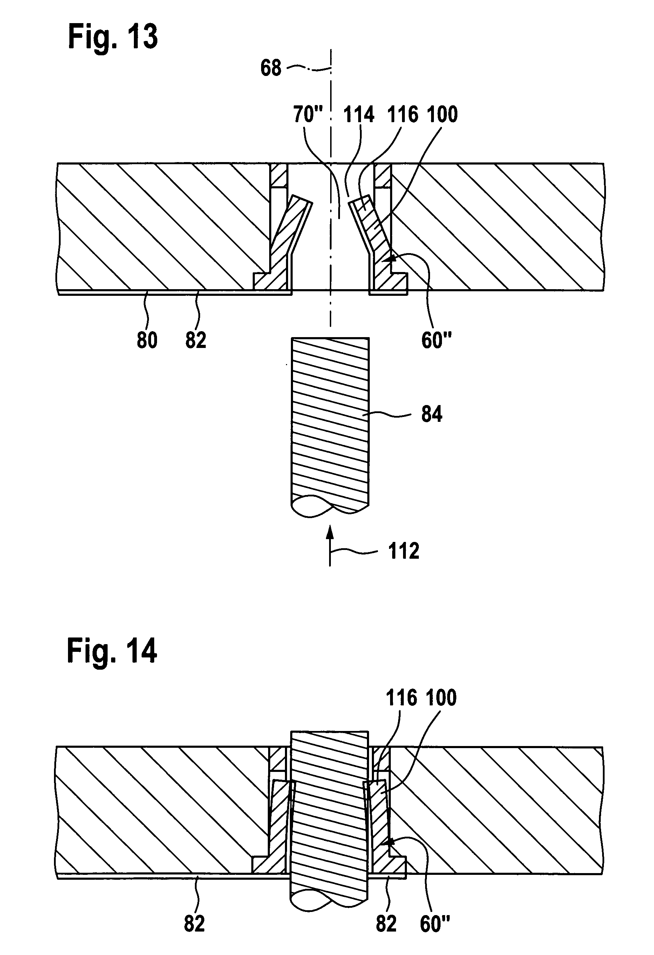

Bei einem fünften Ausführungsbeispiel eines erfindungsgemäßen Formteils sind, wie in Fig. 13 und 14 dargestellt, die Aufnahmeteile 60" im Bereich ihrer Einsteckkanäle 70" mit Federzungen 100 versehen, welche in einer Einsteckrichtung 112 vor Einstecken des Kontaktstifts 84 mit zunehmender Erstreckung in der Einsteckrichtung 112 zunehmend zur Mittelachse 68 hin gerichtet verlaufen und einen im Querschnitt verengten Bereich 114 des Einsteckkanals 70" mit ihren Enden 116 bilden.

Das Einstecken des Kontaktstifts 84 führt nun, wie in Fig. 14 dargestellt dazu, daß sich die Federzungen 100 von der Mittelachse 68 weg aufgeweitet werden und somit mit ihren Enden 116 kraftbeaufschlagt an dem Kontaktstift 84 anliegen und im übrigen in der Art von Widerhaken gegen ein Herausziehen des Kontaktstifts 84 entgegengesetzt zur Einsteckrichtung 112 wirken.

Somit besteht die Möglichkeit, im wesentlichen jede Art von Kontaktstift 84 in den Aufnahmeteilen 60" zu verankern und diesen somit sicher zu kontaktieren.

Im übrigen entsprechen das vierte und fünfte Ausführungsbeispiel den voranstehenden Ausführungsbeispielen, so daß für dieselben Teile dieselben Bezugszeichen Verwendung finden und somit vollinhaltlich auf die Ausführungen zu den voranstehenden Ausführungsbeispielen Bezug genommen werden kann.

## Patentansprüche

1. Mit mindestens einer Leiterbahn (82) versehenes Formteil, umfassend ein Trägerteil (10) aus geformtem Kunststoff, mindestens einen an dem Trägerteil (10) vorgesehenen und die mindestens eine Leiterbahn (82) festlegenden Pfad (44, 46, 48, 50) aus galvanisierbarem Kunststoffmaterial, welcher mindestens eine die mindestens eine Leiterbahn (82) bildende leitfähige Schicht (80) trägt,
**dadurch gekennzeichnet, daß** zur Bildung mindestens einer Anschlußstelle der mindestens einen Leiterbahn (82) in dem Trägerteil (10) ein eine Aufnahme (70) für einen einsetzbaren Kontakt (84) aufweisendes Aufnahmeteil (60) aus einem galvanisierbaren und zugfesteren Material als das Kunststoffmaterial des Trägerteils (10) und/oder des Pfades (44, 46, 48, 50) sitzt, an welches der mindestens eine Pfad (44, 46, 48, 50) angrenzt, und daß die von dem mindestens einen Pfad (44, 46, 48, 50) getragene elektrisch leitfähige Schicht (80) in dessen Aufnahme (70) des Aufnahmeteils (60) hineinverläuft.

2. Formteil nach Anspruch 1, **dadurch gekennzeichnet, daß** das Aufnahmeteil (60) in einen Durchbruch (22, 24, 26, 28) des Trägerteils (10) eingepreßt ist.

3. Formteil nach Anspruch 1, **dadurch gekennzeichnet, daß** das Aufnahmeteil (60) in das Trägerteil (10) eingeformt ist.

4. Formteil nach einem der voranstehenden Ansprüche, **dadurch gekennzeichnet, daß** das Aufnahmeteil ein Verankerungselement (64) aufweist, welches eine formschlüssige Verbindung mit einem dieses umgebenden Wandbereich (12) des Trägerteils (10) eingeht.

5. Formteil nach Anspruch 4, **dadurch gekennzeichnet, daß** das Verankerungselement als Bund (64) ausgebildet ist.

6. Formteil nach Anspruch 5, **dadurch gekennzeichnet, daß** der Bund (64) auf der Seite des Aufnahmeteils (60) angeordnet ist, von welcher ausgehend ein Einsetzen des Kontakts (84) erfolgt.

7. Formteil ach Anspruch 6, **dadurch gekennzeichnet, daß** die Aufnahme (70) so ausgebildet ist, daß zwischen dieser und dem Kontakt (84) eine lötfreie Verbindung herstellbar ist.

8. Formteil nach einem der voranstehenden Ansprüche, **dadurch gekennzeichnet, daß** das Aufnahmeteil (60) als Aufnahme (70) einen Preßsitz für einen einzupressenden Kontakt (84) aufweist.

9. Formteil nach Anspruch 8, **dadurch gekennzeichnet, daß** der Preßsitz (70) eine strukturierte Oberfläche (90) aufweist.

10. Formteil nach einem der voranstehenden Ansprüche, **dadurch gekennzeichnet, daß** das Aufnahmeteil (60") in einen Einsteckkanal (70) desselben hineinragende Federelemente (100) umfaßt.

11. Formteil nach einem der voranstehenden Ansprüche, **dadurch gekennzeichnet, daß** das Aufnahmeteil (60) als Hülse ausgebildet ist.

12. Formteil nach einem der voranstehenden Ansprüche, **dadurch gekennzeichnet, daß** das Aufnahmeteil (60) aus Metall ist.

13. Verfahren zum Herstellen eines mit mindestens einer elektrischen Leiterbahn (82) versehenen Formteils, umfassend die folgenden Schritte:
Herstellen eines Trägerteils (10) als Formteil aus Kunststoff
- Anbringen eines den Verlauf der mindestens einen Leiterbahn (82) festlegenden Pfades (44, 46, 48, 50) aus galvanisierbarem Kunststoffmaterial an dem Trägerteil (10)
- Aufbringen mindestens einer die mindestens eine Leiterbahn (82) bildenden elektrisch leitfähigen Schicht (80) auf dem mindestens einen Pfad (44, 46, 48, 50)
**dadurch gekennzeichnet , daß**dasTrägerteil(10)vor dem Aufbringen der elektrisch leitfähigen Schicht (80) mit einem Aufnahmeteil (60) aus galvanisierbarem und zugfesteren Material als das Kunststoffmaterial des Trägerteils (10) oder des Pfades (44, 46, 48, 50) versehen wird und daß die elektrisch leitfähige Schicht (80) derart aufgebracht wird, daß sie von dem Pfad (44, 46, 48, 50) in eine Aufnahme (70) des Aufnahmeteils (60) hineinverläuft.

14. Verfahren nach Anspruch 13, **dadurch gekennzeichnet, daß** das Anbringen des Pfades (44, 46, 48, 50) aus galvanisierbarem Kunststoffmaterial ein Aufbringen von galvanisierbarem Kunststoffmaterial auf das Trägerteil (10) umfaßt.

15. Verfahren nach Anspruch 13, **dadurch gekennzeichnet, daß** das Anbringen des Pfades (44, 46, 48, 50) aus galvanisierbarem Kunststoffmaterial durch eine oberflächliche Veränderung des Kunststoffmaterials des Trägerteils (10) erfolgt.
